**Europäisches Patentamt**

**European Patent Office**

**Office européen des brevets**

(19)

(11) Numéro de publication : **0 114 548
B1**

(12) **FASCICULE DE BREVET EUROPÉEN**

(45) Date de publication du fascicule du brevet :
30.09.87

(51) Int. Cl.⁴ : **H 01 L 33/00**

(21) Numéro de dépôt : **83402409.3**

(22) Date de dépôt : **13.12.83**

(54) Diode électroluminescente à émission de surface.

(30) Priorité : **21.12.82 FR 8221402**

(43) Date de publication de la demande :
**01.08.84 Bulletin 84/31**

(45) Mention de la délivrance du brevet :
**30.09.87 Bulletin 87/40**

(84) Etats contractants désignés :
**DE GB NL SE**

(56) Documents cités :
**FR-A- 2 390 017
GB-A- 2 087 145
GB-A- 2 092 370
US-A- 3 946 417**

(73) Titulaire : **THOMSON-CSF
173, Boulevard Haussmann
F-75379 Paris Cedex 08 (FR)**

(72) Inventeur : **Henry, Raymond
THOMSON-CSF SCPI 713, bld Haussmann
F-75379 Paris Cedex 08 (FR)**
Inventeur : **Carballes, Jean-Claude
THOMSON-CSF SCPI 713, bld Haussmann
F-75379 Paris Cedex 08 (FR)**
Inventeur : **Mesquida, Guy
THOMSON-CSF SCPI 713, bld Haussmann
F-75379 Paris Cedex 08 (FR)**

(74) Mandataire : **Taboureau, James et al
THOMSON-CSF SCPI 19, avenue de Messine
F-75008 Paris (FR)**

Jouve, 18, rue St-Denis, 75001 Paris, France

## Description

La présente invention concerne une diode électroluminescente à émission de surface, comportant au moins une couche active située entre un substrat et une couche fenêtre, la couche active émettant sous polarisation un rayonnement lumineux isotrope dont une partie est émise à travers la couche fenêtre et une partie est émise en direction du substrat.

Une diode électroluminescente est un composant essentiellement formé par une couche active et au moins une couche de confinement; l'ensemble est porté par un substrat et peut comprendre en outre d'autres couches, de lissage, de prise de contact... etc, qui ne seront pas détaillées dans la suite de ce texte, car elles n'interviennent pas dans l'étude de l'invention. Une diode électroluminescente utilise l'émission spontanée issue de la recombinaison radiative de paires électron-trou créée par l'injection de porteurs dans une jonction polarisée en direct. Le rayonnement spontané est isotrope.

Deux cas se présentent.

Dans une diode électroluminescente à émission de surface, dont le substrat est opaque à la longueur d'onde émise, le spectre optique associé à l'émission comporte un ou deux pics plus ou moins distincts suivant la nature de la couche active.

Une solution à ce problème de réémission lumineuse par le substrat est apportée par le brevet GB-A-2 092 370, déposé le 3 Février 1981, et qui traite d'un dispositif de visualisation par diodes électroluminescentes, dont les informations, lettres ou sigles, sont rendues floues par la lumière réémise par le substrat. Pour y remédier, une couche absorbante est interposée, pour chaque diode, entre la couche active émettrice de lumière et le substrat, et cette couche est elle même comprise entre deux couches de confinement en $GaAs_{1-x}P_x$, dont le taux de phosphore croit en s'éloignant de la couche absorbante. Les deux couches de confinement s'opposent donc à la transmission de la lumière qui pourrait être réémise par la couche absorbante.

Si par contre le substrat est transparent à la longueur d'onde émise, il ne réémet pas puisqu'il n'aborde pas, mais une moitié environ de la lumière émise est perdue : celle qui sort par la face arrière de la diode, c'est-à-dire à travers le substrat.

Du fait de la répartition quasi lambertienne du faisceau émis, le rendement d'une diode électroluminescente est assez médiocre, surtout en couplage avec une fibre optique. Afin d'augmenter le rendement d'une diode électroluminescente et d'obtenir un spectre plus pur, l'invention prévoit d'ajouter à la structure de la diode électroluminescente une couche, placée sur le parcours arrière de la lumière émise, de nature très voisine de celle de la couche active, mais d'énergie de bande interdite inférieure à celles des couches de confinement et de la couche active : cette couche supplémentaire absorbe le rayonnement émis à une longueur d'onde $\lambda$ par la couche active, et la réémet par photoluminescence à une longueur d'onde très voisine $\lambda + \Delta\lambda$. Ainsi la puissance optique émise est augmentée par l'émission photoluminescente, et la largeur de raie du spectre optique est légèrement augmentée, mais le pic parasite d'émission du substrat est considérablement diminué, voire annulé dans certains cas.

De façon plus précise, l'invention concerne une diode électroluminescente à émission de surface, comportant au moins une couche active située entre un substrat et une couche fenêtre, la couche active émettant, sous polarisation, un rayonnement lumineux isotrope dont une partie est émise à travers la couche fenêtre et une partie est émise en direction du substrat, cette diode étant caractérisée en ce qu'une couche, constituée d'un matériau dont la hauteur de bande interdite est voisine mais inférieure à la hauteur de bande interdite du matériau de la couche active, absorbe le rayonnement émis en direction du substrat et le réémet par photoluminescence, de façon isotrope, à une longueur d'onde $\lambda + \Delta\lambda$ très voisine de la longueur d'onde de la couche active.

L'invention sera mieux comprise par la description qui suit de deux exemples de réalisation, concernant les deux cas où le substrat est opaque et où le substrat est transparent à la longueur d'onde émise, cette description s'appuyant sur les figures jointes en annexe et qui représentent :

figure 1   vue en coupe d'une diode électroluminescente selon l'art connu, dans le cas d'un substrat opaque,

figure 2   spectre d'énergie de la diode électroluminescente précédente,

figure 3   vue en coupe d'une diode électroluminescente selon l'invention, dans le cas d'un substrat opaque,

figure 4   spectre d'énergie de la diode électroluminescente de la figure 3,

figure 5   vue en coupe d'une diode électroluminescente selon l'invention dans une première variante,

figure 6   spectre d'énergie de la diode électroluminescente de la figure 5,

figure 7   vue en coupe d'une diode électroluminescente selon l'art connu, dans le cas d'un substrat transparent

figure 8   vue en coupe d'une diode électroluminescente selon l'invention dans le cas d'un substrat transparent.

Il existe un grand nombre de types de diodes électroluminescentes, qui varient selon leurs structures ou selon leurs matériaux constitutifs. Une diode électroluminescente peut être à homojonction, à simple ou à double hétérojonction, et elle peut être réalisée en divers matériaux tels que ceux des familles GaAs, AlGaAs, InP, InGaAs, InGaAsP, ... etc. Afin d'être plus précis dans l'exposé de l'invention, celle-ci s'appuiera sur deux cas : celui d'une diode GaAs-AlGaAs dont le

substrat en GaAs est opaque au rayonnement, voisin de 840 nanomètres, et celui d'une diode dont le substrat en InP est transparent au rayonnement, voisin de 1 300 nanomètres.

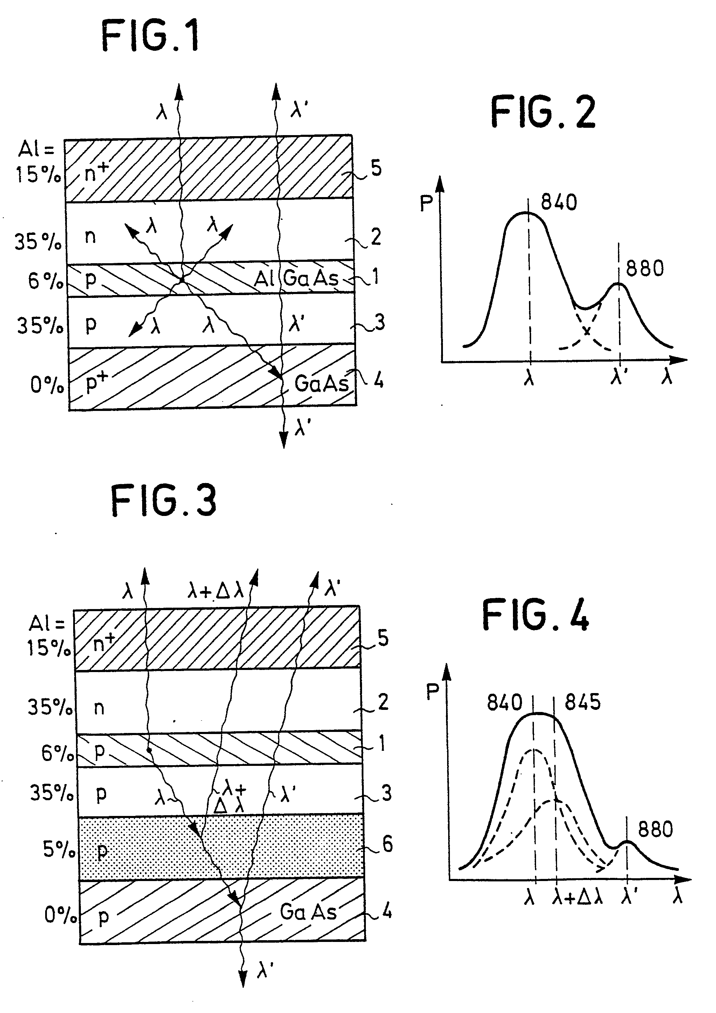

La figure 1 représente une vue en coupe d'une diode électroluminescente selon l'art connu. Celle-ci est essentiellement constituée par une couche 1, dite active, comprise entre deux couches de confinement 2 et 3, et formant avec elles, aux deux interfaces, deux hétérojonctions. Dans les cas les plus simples, cette diode est complétée par au moins un substrat 4, qui sert à la fois de support mécanique aux fines couches déposées à partir du substrat, et de premier contact électrique, et en outre par une couche de surface 5 dite couche fenêtre, destinée à la prise d'un second contact électrique et transparente au rayonnement émis. La couche active 1 est en $Al_x$-$Ga_{1-x}As$, de dopage de type p, comportant 6 % d'aluminium. Les deux couches de confinement 2 et 3 sont toutes deux en $Al_x$-$Ga_{1-x}As$, comportant 35 % d'aluminium, la couche de confinement 2 située entre la couche active 1 et la surface émissive de la diode étant de dopage de type n, tandis que la couche de confinement 3 située entre la couche active 1 et le substrat 4 est de dopage de type p. Le substrat 4 étant en GaAs de type $p^+$, il comporte donc 0 % d'aluminium. Enfin la couche 5 de prise de contact, qui constitue la fenêtre de sortie du rayonnement et la surface émissive de la diode, par opposition avec la surface opaque du substrat 4, est en $Al_{x''}Ga_{1x''}As$, de type de dopage $n^+$ et comportant 15 % d'aluminium.

Le taux d'aluminium contenu dans une couche règle la hauteur de bande interdite de ladite couche et par conséquent impose la longueur d'onde d'émission propre de la couche. Une diode électroluminescente fonctionnant en régime d'émission spontanée, le rayonnement de chaque point émissif s'effectue de manière isotrope dans l'espace, ce qui est représenté sur la figure 1 sous forme d'un rayonnement qui, à partir d'un élément de la couche active 1, se propage dans toutes les directions de l'espace. Les couches de confinement 2 et 3 et la couche fenêtre 5 ayant des concentrations en aluminium supérieures à celles de la couche active 1, qui n'en comporte que 6 %, sont transparentes au rayonnement de cette couche active. Par conséquent, à partir d'un élément de volume de la couche active 1, le rayonnement de longueur d'onde $\lambda$ sort en partie par la couche fenêtre 5, est en partie perdu latéralement par rapport à la structure de la diode électroluminescente, et vient en partie frapper le substrat en GaAs opaque à cette longueur d'onde $\lambda$.

La partie du rayonnement arrivant jusqu'au substrat 4 est absorbée par ce dernier et la perte d'énergie associée à cette absorption permet la réémission par le substrat GaAs, par photoluminescence, à une longueur d'onde propre au substrat, c'est-à-dire dans le cas d'exemple choisi voisine de 880 nanomètres. Une partie de l'émission du substrat, à sa longueur d'onde propre $\lambda'$,

traverse la diode sans être absorbée ni par la couche active ni par les couches de confinement et sort donc par la couche fenêtre 5 ce qui fait que, lors de l'analyse spectrale du composant électroluminescent, la longueur d'onde $\lambda'$ propre au substrat est pris en compte à côté de la longueur $\lambda$ propre à la couche active.

La figure 2 représente la puissance optique de la diode électroluminescente, portée en ordonnées, par rapport aux longueurs d'onde portées en abcisse. Elle met en évidence que pour une diode du type GaAs-AlGaAs, il y a un pic de puissance voisin de 840 nanomètres, et un plus petit pic de puissance voisin de 880 nanomètres, qui correspond à la puissance émise par photoluminescence par le substrat. L'enveloppe de ces deux pics donne l'analyse spectrale du composant. Le pic parasite à 880 nanomètres peut représenter jusque 40 % de la puissance optique du pic principal à 840 nanomètres. Cette dualité spectrale peut compromettre l'utilisation de la diode électroluminescente dans un certain nombre d'applications, en particulier celles dans lesquelles est utilisé le multiplexage en longueur d'onde : dans ces utilisations, il est nécessaire que la largeur des raies soit la plus faible possible et que celle-ci soit définie le mieux possible. Or, en règle générale, le phénomène d'émission parasite augmente la largeur des spectres des diodes obtenues selon l'art connu : il faut donc supprimer l'émission parasite.

La figure 3 représente en vue en coupe d'une diode électroluminescente selon l'invention, dans le cas d'un substrat opaque. Par rapport à la coupe de diode électroluminescente selon l'art connu de la figure 1, la diode selon l'invention comporte, placée entre le substrat 4 et la couche de confinement 3 qui est la plus proche du substrat, une couche supplémentaire 6 en $Al_y$-$Ga_{1-y}As$, de conductivité de type p et contenant 5 % d'aluminium. De façon plus générale, le pourcentage d'aluminium dans la couche réémettrice 6 doit être le plus proche possible du pourcentage d'aluminium de la couche émettrice 1, mais très légèrement inférieur à celui-ci, de façon à ce que la bande interdite de la couche réémettrice soit très proche de la bande interdite de la couche émettrice 1 et en tout cas inférieur à la bande interdite de la couche de confinement 3.

Dans une structure selon l'invention, un élément de volume de la couche émettrice 1 émet de la lumière à longueur d'onde $\lambda$ en direction de la couche fenêtre 5 mais également, entre autres, en direction du substrat 4 : le rayonnement qui se dirige vers le substrat est, pour une épaisseur de couche suffisante, absorbé par la couche réémettrice 6 et réémis par photoluminescence. Ainsi, à partir de la couche réémettrice 6, un rayonnement photoluminescent de longueur d'onde $\lambda + \Delta\lambda$ très proche de la longueur d'onde $\lambda$ de la couche émettrice 1 se propage en partie vers la couche fenêtre 5 et en partie vers le substrat. La partie de ce rayonnement $\lambda + \Delta\lambda$ qui est absorbée par le substrat 4 est à son tour réémise de façon isotrope à la longueur d'onde parasite $\lambda'$.

La figure 4 représente la courbe de puissance optique d'une diode selon l'invention, en fonction de la longueur d'onde. Par rapport à la courbe de la figure 2, qui représentait la puissance optique d'une diode selon l'art connu, le pic de puissance optique principal est très légèrement élargi car il est désormais constitué par la somme de deux pics : celui qui correspond à l'émission de la couche active 1, c'est-à-dire dans le cas présent le pic à 840 nanomètres, et celui qui correspond à la réémission par photoluminescence de la couche réémettrice 6, c'est-à-dire dans le cas présent de l'ordre de 845 nanomètres. L'enveloppe, ou plus exactement la somme de ces deux pics d'énergie, permet d'obtenir un pic de puissance principal qui est plus important que celui de la seule couche active, au prix d'un léger aplatissement au sommet du pic puisque celui-ci est très légèrement élargi par la lumière réémise par photoluminescence.

Par ailleurs, et sur un plan totalement indépendant de la photoluminescence, la présence de la couche réémettrice 6 apporte un avantage en ce sens qu'elle sert de couche de lissage sur le substrat et qu'elle permet de mieux adapter la croissance de la première couche de confinement en GaAlAs sur le substrat de GaAs, minimisant ainsi les contraintes éventuelles, et bloquant, au cours de l'épitaxie, la migration des défauts du substrat vers les couches.

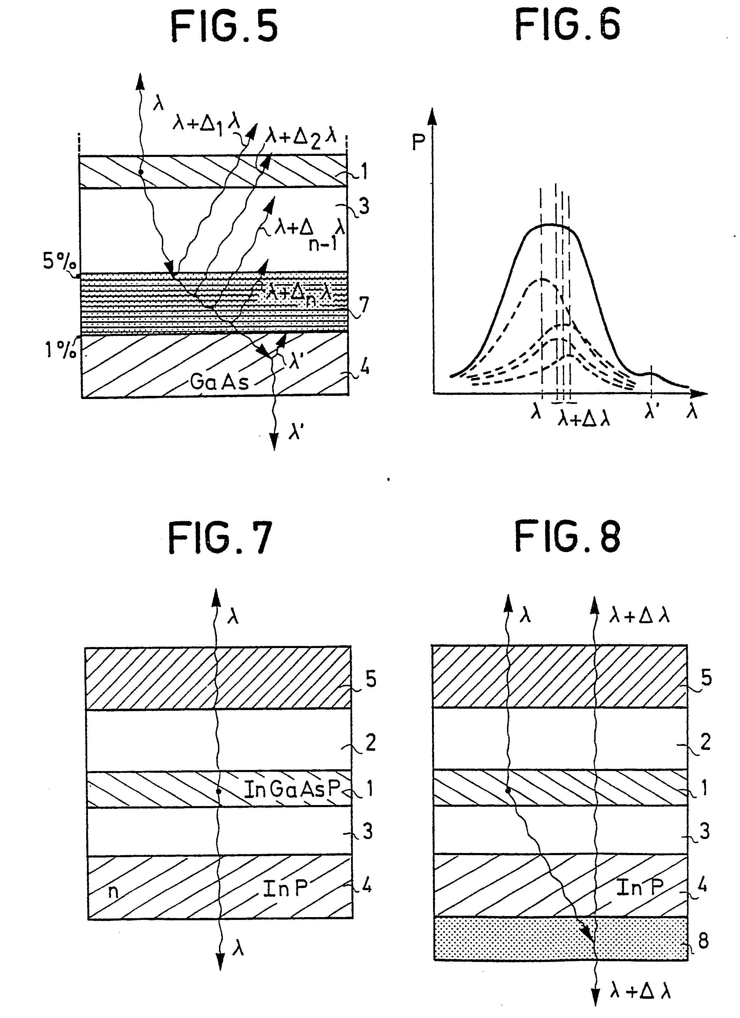

La figure 5 représente une vue en coupe d'une diode électroluminescente selon l'invention, dans le cas d'une variante qui permet encore d'accentuer cet avantage. Seule la partie inférieure, c'est-à-dire la partie de la diode comprise entre la couche active et le substrat est représentée pour simplifier la figure.

Selon cette variante à l'invention, la couche réémettrice n'est plus comme dans le cas de la figure 3 constituée par une unique couche 6 de matériau homogène, mais elle est constituée par un ensemble 7 de couches plus fines, chaque couche ayant une teneur en aluminium, ou de façon plus générale une bande interdite, qui varie de façon continue depuis le substrat en direction de la couche active 1. Pour être plus concret, et toujours dans le cas où le substrat est GaAs opaque à 840 nanomètres, la première couche située au contact du substrat comporte 1 % d'aluminium, la seconde couche 2 %, et ainsi de suite jusqu'à la dernière couche qui comporte 5 % d'aluminium, si la couche active 1 en comporte quant à elle 6 %.

Selon cette structure de diode, le rayonnement émis par un élément de volume de la couche active 1, à une longueur d'onde λ, en direction du substrat 4 de GaAs est absorbé par la dernière des couches constituant la couche réémettrice 7, c'est-à-dire la couche qui est en contact avec la couche de confinement 3. Le rayonnement absorbé dans cette couche réémettrice est alors réémis par photoluminescence à une longueur d'onde λ + Δ₁λ, correspondante au taux d'aluminium dans ladite couche. Le rayonnement de longueur d'onde λ + Δ₁λ, qui est lui-même émis de façon isotrope dans toutes les directions, est à son tour absorbé par la couche suivante et réémis à une longueur d'onde λ + Δ₂λ et ainsi de suite jusqu'à la première couche, en contact avec le substrat, laquelle réémet à une longueur d'onde λ + Δₙλ. Le substrat lui-même reçoit un certain rayonnement qui en fait est un mélange des rayonnements de la couche active et des couches émettrices 7 mais ne réémet qu'une très faible partie à une longueur d'onde parasite λ'.

La figure 6 montre le spectre d'énergie d'une diode électroluminescente selon cette première variante de l'invention. Par comparaison avec le spectre de la figure 4, le pic d'énergie principal est très légèrement élargi du fait qu'il n'est plus obtenu par la seule association d'un pic d'énergie correspondant à la couche active 1 et un seul pic d'énergie correspondant à la couche réémettrice 6, mais qu'il est obtenu par association du pic d'énergie de la couche émettrice 1 avec une pluralité de petits pics d'énergie des sous-couches réémettrices 7. Par contre le pic d'énergie parasite à 880 nanomètres a pratiquement disparu.

La figure 7 représente une vue en coupe d'une diode électroluminescente selon l'art connu, dans le seconed cas, selon lequel le substrat est transparent à la longueur d'onde émise.

Ce type de diode est essentiellement constitué par une couche active 1 en Ga$_x$In$_{1-x}$As$_y$P$_{1-y}$ par exemple, limitée par une double hétérojonction entre deux couches de confinement 2 et 3 qui sont toutes deux en InP, l'ensemble étant supporté par un substrat 4 en InP également. La lumière émise par la couche active lorsqu'elle est polarisée sort à travers la fenêtre 5, sur la face supérieure de la diode électroluminescente, mais sort également à travers le substrat 4 en InP puisque celui-ci est transparent. Dans le cas où la diode est une association entre les couches de InP et de InGaAsP, ou d'autres matériaux voisins, la longueur d'onde émise est voisine de 1 300 nanomètres. Entre 1 200 et 65 000 nanomètres, x et y dans le composé Ga$_x$In$_{1-x}$As$_y$P$_{1-y}$ sont liés par la relation :

$$x = 0{,}189 \, y/0{,}4184 - 0{,}134 \, y$$

avec $0{,}5 < y < 1$ et $0{,}22 < x < 0{,}47$.

Une diode émissive à 1 300 nanomètres, du genre de celle représentée en figure 7, peut être adaptée et recevoir une structure selon l'invention conforme à la structure exposée en figure 3 et à sa variante de la figure 5. Dans ce cas, il faut disposer entre le substrat et la couche de confinement 3 — celle qui se trouve située entre la couche active 1 et le substrat 4 — une couche réémettrice qui peut être soit uniforme dans son épaisseur et sans gradient de dopage telle que la couche 6 de la figure 3, ou qui peut être constituée par une suite de fines couches présentant un gradient de dopage telle que représentée en 7 sur la figure 5. L'important est que la couche réémettrice ait une bande interdite légèrement inférieure à celle de la couche active.

Cependant, et uniquement dans le cas où le substrat est transparent à la longueur d'onde émise, un second cas de figure peut être intéressant. C'est celui qui est représenté en figure 8.

La différence existant entre la structure de la figure 8 et la structure de la figure 3 est que la couche réémettrice est située, en 8 sur la figure 8 derrière le substrat, vu depuis la couche active, tandis que dans la structure de la figure 3 la couche réémettrice 6 était située devant le substrat, vu depuis la couche émettrice.

Dans le cas où la couche réémettrice 8 est située derrière le substrat, la lumière émise par un élément de volume de la couche active traverse la couche de confinement 3 et le substrat 4 avant d'être absorbée par la couche réémettrice 8. Celle-ci transforme l'énergie absorbée et la réémet sous la forme d'un rayonnement de longueur d'onde très voisin λ + Δλ, mais, comme la couche réémettrice est située à l'extérieur de la structure, le rayonnement réémis par photoluminescence est dirigé en partie vers la couche fenêtre 5, ce qui est l'un des objectifs recherché à l'origine, mais également en partie vers la partie arrière de la diode électroluminescente. Le fait qu'un rayonnement sorte par la partie arrière de la diode électroluminescente est, dans certain cas, recherché, afin de pouvoir contrôler la lumière émise par une diode, et assurer par exemple une contre-réaction en fonction de cette lumière émise.

L'invention a été décrite en s'appuyant sur les deux cas les plus courants actuellement, à 840 et à 1 300 nanomètres, qui correspondent également à deux cas intéressants où le substrat est soit opaque soit transparent. Néanmoins, l'invention s'applique à toutes diodes électroluminescentes, quels que soient les matériaux dont elle est constituée, alliage binaire ou ternaire des familles III.V. L'invention s'applique également à toutes diodes électroluminescentes quelle que soit leur structure : afin de simplifier l'exposé, la structure des diodes a été volontairement simplifiée en supprimant un certain nombre de couches auxilliaires qui ont leur usage mais qui n'intervenaient pas dans l'exposé de l'invention. L'invention s'applique également au cas de diodes qui ne comportent qu'une homojonction, ou une simple hétérojonction et non pas une double hétérojonction. Le principe général de l'invention est de remplacer la partie située du côté du substrat dans une diode, et qui soit laisse s'échapper de la lumière par la face arrière soit l'absorbe totalement, par ce qu'on pourrait comparer avec un réémetteur, la couche réémettrice, caractéristique de l'invention, absorbant la lumière émise vers le substrat, et la réémettant vers la fenêtre à une longueur d'onde très proche de celle de la couche active. De façon plus générale l'invention est précisée par les revendications ci-après.

**Revendications**

1. Diode électroluminescente à émission de surface, comportant au moins une couche active (1) située entre un substrat (4) et une couche fenêtre (5), la couche active (1) émettant, sous polarisation, un rayonnement lumineux isotrope dont une partie est émise à travers la couche fenêtre (5) et une partie est émise en direction du substrat (4), cette diode étant caractérisée en ce qu'une couche (6), constituée d'un matériau dont la hauteur de bande interdite est voisine mais inférieure à la hauteur de bande interdite du matériau de la couche active (1), absorbe le rayonnement émis en direction du substrat (4) et le réémet par photoluminescence, de façon isotrope, à une longueur d'onde λ + Δλ très voisine de la longueur d'onde λ de la couche active (1).

2. Diode électroluminescente selon la revendication 1, caractérisée en ce que, la diode comportant en outre au moins une couche de confinement (3) située entre la couche active (1) et le substrat (4), la couche réémettrice (6) est située entre la couche de confinement (3) et le substrat (4) et est de composition homogène sur toute son épaisseur.

3. Diode électroluminescente selon la revendication 1, caractérisée en ce que, la diode comportant au moins une couche de confinement (3) située entre la couche active (1) et le substrat (4), la couche réémettrice est située entre la couche de confinement (3) et le substrat (4) et est composée d'une pluralité (7) de sous-couches de composition variable, dont la hauteur de bande interdite croît depuis la sous-couche en contact avec le substrat (4) jusqu'à la sous-couche en contact avec la couche de confinement (3).

4. Diode électroluminescente selon la revendication 1, caractérisée en ce que, le substrat (4) étant transparent à la longueur d'onde du rayonnement émis par la couche active (1), le substrat est situé entre la couche de confinement (3) et la couche réémettrice (8), qui émet par la face « arrière » de la diode un rayonnement prélevé pour le contrôle ou la contre réaction de fonctionnement de la diode.

5. Diode électroluminescente selon la revendication 1, caractérisée en ce que :
le substrat (4) est en GaAs, dopé p$^+$
la couche réémettrice (6) est en $Al_yGa_{1-y}As$, p, contenant 5 % Al (y ≃ 0,05),
la couche de confinement inférieure (3) est en $Al_{x'}Ga_{1-x'}As$, p, contenant 35 % Al (x' ≃ 0,35),
la couche active (1) est en $Al_xGa_{1-x}As$, p, contenant 6 % Al (x ≃ 0,06),
la couche de confinement supérieure (2) est en $Al_{x'}Ga_{1-x'}As$, n, contenant 35 % Al (x ≃ 0,35),
la couche fenêtre (5) est en $Al_xGa_{1-x}As$, n$^+$, contenant 5 % Al (x ≃ 0,05),

6. Diode électroluminescente selon la revendication 1, caractérisée en ce que :
le substrat (4) est en GaAs, dopé p$^+$
la couche réémettrice (7) est en $Al_yGa_{1-y}As$, p, constituée d'une pluralité de sous-couches contenant de 1 % (côté substrat) à 5 % (côté couche de confinement) de Al
la couche de confinement inférieure (3) est en $Al_{x'}Ga_{1-x'}As$, p, contenant 35 % Al (x' ≃ 0,35),
la couche active (1) est en $Al_xGa_{1-x}As$, p,

contenant 6 % Al (x ≃ 0,06),

la couche de confinement supérieure (2) est en $Al_{x'}Ga_{1-x'}As$, n, contenant 35 % Al (x' ≃ 0,35),

la couche fenêtre (5) est en $Al_{x''}Ga_{1-x''}As$, n+, contenant 5 % Al (x'' ≃ 0,05).

7. Diode électroluminescente selon la revendication 1, caractérisée en ce que :

le substrat (4) est en InP

la couche réémettrice (6 ou 8) est en $Ga_xIn_{1-x}As_yP_{1-y}$

la couche de confinement inférieure (3) est en InP

la couche active (1) est en $Ga_xIn_{1-x}As_yP_{1-y}$

la couche de confinement supérieure (2) est en InP

la couche fenêtre (5) est en InP, avec 0,22 ≤ x ≤ 0,47 et 0,5 ≤ y ≤ 1 pour les deux couches réémettrices (6 ou 8) et active (1).

## Claims

1. An electroluminescent diode of the surface emission type, comprising at least one active layer (1) located between a substrate (4) and a window layer (5), the active layer (1) emitting under polarisation an isotropic light radiation, a portion of which is emitted through the window layer (5) and another portion towards the substrate (4), this diode being characterized in that a layer (6), constituted of a material having a forbidden band of a height slightly smaller than the height of the forbidden band of the material in the active layer (1), absorbs the radiation emitted towards the substrate (4) and retransmits it by photoluminescence in an isotropic manner and at a wavelength $\lambda + \Delta\lambda$ very close to the wavelength $\lambda$ of the active layer (1).

2. An electroluminescent diode according to claim 1, characterized in that, the diode further including at least one confinement layer (3) located between the active layer (1) and the substrate (4), the retransmitting layer (6) is located between the confinement layer (3) and the substrate (4) and is of a homogeneous composition over its entire thickness.

3. An electroluminescent diode according to claim 1, characterized in that, the diode including at least one confinement layer (3) located between the active layer (1) and the substrate (4), the retransmitting layer is located between the confinement layer (3) and the substrate (4) and is composed of a plurality (7) of sub-layers of variable composition, the height of the forbidden band increasing from the sub-layer in contact with the substrate (4) up to the sub-layer in contact with the confinement layer (3).

4. An electroluminescent diode according to claim 1, characterized in that, the substrate (4) being transparent at the wavelength of the radiation emitted by the active layer (1), the substrate is located between the confinement layer (3) and the retransmitting layer (8), which transmits through the rear surface of the diode a radiation used for the control or the operational feedback of the diode.

5. An electroluminescent diode according to claim 1, characterized in that

the substrate (4) is made of p+-doped GaAs, the retransmitting layer (6) is made of $Al_yGa_{1-y}As$, p, with 5 % Al (y ~ 0,05),

the lower confinement layer (3) is made of $Al_{x'}Ga_{1-x'}As$, p with 35 % Al (x' ~ 0,35),

the active layer (1) is made of $Al_xGa_{1-x}As$, p with 6 % Al (x ~ 0,06),

the upper confinement layer (2) is made of $Al_{x'}Ga_{1-x'}As$, n with 35 % Al (x ~ 0,35),

the window layer (5) is made of $Al_{x''}Ga_{1-x''}As$, n+, with 5 % Al (x'' ~ 0,05).

6. An electroluminescent diode according to claim 1, characterized in that

the substrate (4) is made of p+-doped GaAs,

the retransmitting layer (7) is made of $Al_yGa_{1-y}As$, p, and is constituted of a plurality of sub-layers containing from 1 % (on the substrate side) to 5 % of Al (on the side of the confinement layer),

the lower confinement layer (3) is made of $Al_{x'}Ga_{1-x'}As$, p with 35 % Al (x' ~ 0,35),

the active layer (1) is made of $Al_xGa_{1-x}As$, p with 6 % Al (x ~ 0,06),

the upper confinement layer (2) is made of $Al_{x'}Ga_{1-x'}As$, n with 35 % Al (x' ~ 0,35),

the window layer (5) is made of $Al_{x''}Ga_{1-x''}As$, n+ with 5 % Al (x'' ~ 0,05).

7. An electroluminescent diode according to claim 1, characterized in that

the substrate (4) is made of InP,

the retransmitting layer (6 or 8) is made of $Ga_xIn_{1-x}As_yP_{1-y}$,

the lower confinement layer (3) is made of InP,

the active layer (1) is made of $Ga_xIn_{1-x}As_yP_{1-y}$,

the upper confinement layer (2) is made of InP,

the window layer (5) is made of InP, with 0,22 ≤ x ≤ 0,47 and 0,5 ≤ Y ≤ 1 as far as the retransmitting layer (6 or 8) and the active layer (1) are concerned.

## Patentansprüche

1. Elektrolumineszenzdiode mit Oberflächenemission, die mindestens eine aktive Schicht (1) zwischen einem Substrat (4) und einer Fensterschicht (5) enthält, wobei die aktive Schicht unter Polarisation eine isotrope Lichtstrahlung aussendet und zwar einen Teil durch die Fensterschicht (5) und einen anderen Teil in Richtung auf das Substrat (4), dadurch gekennzeichnet, daß eine Schicht (6) aus einem Material, dessen verbotenes Band geringfügig weniger breit als das des Materials der aktiven Schicht (1) ist, die in Richtung auf das Substrat (4) ausgesandte Strahlung absorbiert und durch Fotolumineszenz auf isotrope Weise und mit einer Wellenlänge $\lambda + \Delta\lambda$ wieder aussendet, die der Wellenlänge $\lambda$ der aktiven Schicht (1) sehr nahekommt.

2. Elektrolumineszenzdiode nach Anspruch 1, dadurch gekennzeichnet, da%, sofern die Diode weiterhin mindestens eine Begrenzungsschicht (3) zwischen der aktiven Schicht (1) und dem Substrat (4) aufweist, die das Licht wiederaussendende Schicht (6) zwischen der Begrenzungsschicht (3) und dem Substrat (4) liegt und einen homogenen Aufbau über ihre ganze Dicke besitzt.

3. Elektrolumineszenzdiode nach Anspruch 1, dadurch gekennzeichnet, daß, sofern die Diode mindestens eine Begrenzungsschicht zwischen der aktiven Schicht (1) und dem Substrat (4) aufweist, die das Licht wiederaussendende Schicht zwischen der Begrenzungsschicht (3) und dem Substrat (4) liegt und aus einer Vielzahl (7) von Unterschichten variablen Aufbaus zusammengesetzt ist, deren verbotenes Band in der Breite von der mit dem Substrat (4) in Berührung stehenden Unterschicht bis zur mit der Begrenzungsschicht (3) in Kontakt stehenden Unterschicht ansteigt.

4. Elektrolumineszenzdiode nach Anspruch 1, dadurch gekennzeichnet, daß, sofern das Substrat (4) für die Wellenlänge der von der aktiven Schicht (1) ausgesandten Strahlung durchlässig ist, das Substrat zwischen der Begrenzungsschicht (3) und der das Licht wiederaussendenden Schicht (8) liegt, die über die rückwärtige Seite der Diode eine Strahlung aussendet, die für die Kontrolle oder die Betriebsrückkopplung der Diode verwendet wird.

5. Elektrolumineszenzdiode nach Anspruch 1, dadurch gekennzeichnet, daß

das Substrat (4) aus $p^+$-dotiertem GaAs ist,

die das Licht wiederaussendende Schicht (6) aus $Al_yGa_{1-y}As$, p, mit 5 % Al besteht ($y \sim 0,05$)

die untere Begrenzungsschicht (3) aus $Al_{x'}Ga_{1-x'}As$, p mit 35 % Al ist ($x' \sim 0,35$),

die aktive Schicht (1) aus $Al_xGa_{1-x}As$, p mit

6 % Al ist ($x \sim 0,06$),

die obere Begrenzungsschicht (2) aus $Al_{x'}Ga_{1-x'}As$, n mit 35 % Al ist ($x \sim 0,35$),

die Fensterschicht (5) aus $Al_{x''}Ga_{1-x''}As$, $n^+$ mit 5 % Al ist ($x'' \sim 0,05$).

6. Elektrolumineszenzdiode nach Anspruch 1, dadurch gekennzeichnet, daß

das Substrat (4) aus $p^+$-dotiertem GaAs besteht,

die das Licht wiederaussendende Schicht (7) aus $Al_yGa_{1-y}As$, p besteht, die aus einer Vielzahl von Unterschichten mit zwischen 1 % (Substratseite) und 5 % (Begrenzungsschicht-Seite) Aluminiumanteil zusammengesetzt ist,

die untere Begrenzungsschicht (3) aus $Al_{x'}Ga_{1-x'}As$, p mit 35 % Al besteht ($x' \sim 0,35$),

die aktive Schicht (1) aus $Al_xGa_{1-x}As$, p mit 6 % Al besteht ($x \sim 0,06$),

die obere Begrenzungsschicht (2) aus $Al_{x'}Ga_{1-x'}As$, n mit 35 % Al besteht ($x' \sim 0,35$),

die Fensterschicht (5) aus $Al_{x''}Ga_{1-x''}As$, $n^+$ mit 5 % Al besteht ($x'' \sim 0,05$).

7. Elektrolumineszenzdiode nach Anspruch 1, dadurch gekennzeichnet, daß

das Substrat (4) aus InP besteht,

die das Licht wiederaussendende Schicht (6 oder 8) aus $Ga_xIn_{1-x}As_yP_{1-y}$ ist,

die untere Begrenzungsschicht (3) aus InP besteht,

die aktive Schicht (1) aus $Ga_xIn_{1-x}As_yP_{1-y}$ ist,

die obere Begrenzungsschicht (2) aus InP besteht und

die Fensterschicht (5) aus InP ist,

mit $0,22 \leq x \leq 0,47$ und $0,5 \leq y \leq 1$ für die das Licht wiederaussendende Schicht (6 oder 8) und die aktive Schicht (1).

FIG.1

FIG.2

FIG.3

FIG.4

# FIG.5

# FIG.6

# FIG.7

# FIG.8

2